# EUROPEAN PATENT APPLICATION

(11) **EP 2 317 205 A1**
(43) Date of publication of application: **04.05.2011**
(21) Application number: 09174180.1
(22) Date of filing: 27.10.2009
(51) Int. Cl.: F21K 99/00, F21V 31/00, H01L 25/075, H01L 33/62, H01L 33/54

(54) **Housing of LED light source comprising electrical connector**

(71) Applicant: Liang Meng Plastic Share Co. Ltd., Shuin City T'ai pei 238 (TW)
(72) Inventor: Lai, Guang-Juh, 238, Shulin City, Taipei County (TW)
(74) Representative: 2K Patentanwälte Blasberg Kewitz & Reichel

(57) **Abstract**

An electrical conductive covering structure of an illuminating device (8) includes a substrate (81) and a plurality of light-emitting elements (82). The electrical conductive covering structure includes an electrical conductive circuit (10), an electrical connector (20), a transparent body (30), and a lamp cover (40). The electrical conductive circuit (10) is arranged on a surface of the substrate (81) and electrically connected to the light-emitting elements (82). The electrical connector (20) is fixed to the substrate (81) and electrically connected to the electrical conductive circuit (10). The transparent body (30) is over-molded outside the electrical conductive circuit (10) and the electrical connector (20). The lamp cover (40) is over-molded outside the electrical connector (20) and the transparent body (30). With this structure, the influence of humidity and moisture on the illuminating device (8) can be minimized, thereby increasing its anti-oxidant property and lifetime.

## Description

### BACKGROUND OF THE INVENTION

### 1. Field of the Invention

The present invention relates to an electrical conductive covering structure, and in particular to an electrical conductive covering structure of an illuminating device.

### 2. Description of Prior Art

Because light emitting diodes (LED) have advantages such as good brightness, long life and low electricity consumption, they have been widely used in illuminating devices in the indoors or outdoors. The illuminating device may suffer damage because electrical elements therein may be influenced by temperature, humidity, or oxidization. Thus, the present Inventor proposes the present invention in order to solve the above-mentioned problems.

The conventional illuminating device includes a lamp cover, a light-emitting module, and a transparent glass. The transparent glass is fixed to one side of the lamp cover, and an accommodating space is formed between the transparent glass and the lamp cover. The light-emitting module is mounted in the accommodating space, and it is constituted of a circuit board connected to the lamp cover and a plurality of LEDs arranged on the circuit board. The LEDs illuminate toward the transparent glass. With the above arrangement, the illuminating device can be obtained.

However, in practice, such an illuminating device still has problems as follows. The light-emitting module is mounted in the accommodating space, and there is a great amount of air in the accommodating space. Thus, when electrical circuit is exposed to the air, the electrical circuit may be oxidized easily, which will deteriorate the electrical-conducting efficiency of the electrical circuit. Even, the life of the whole illuminating device may be reduced. Another problem is the elements of the illuminating device are assembled together one by one, which takes a lot of working hours and labors to complete the assembly. As a result, the production rate cannot be increased, which deteriorates the practicability and economic effectiveness of the illuminating device. Therefore, it is an important issue for the present Inventor to solve the above-mentioned problems.

### SUMMARY OF THE INVENTION

The present invention is to provide an electrical conductive covering structure of an illuminating device, whereby the electrical conductive circuit and the electrical connector can be sealed and covered. With this structure, the influence of humidity and moisture on the illuminating device can be minimized, thereby increasing its lifetime.

The present invention is to provide an electrical conductive covering structure of an illuminating device. The illuminating device includes a support and a plurality of light-emitting elements. The electrical conductive covering structure includes an electrical conductive circuit, an electrical connector, a transparent body, and a lamp cover. The electrical conductive circuit is arranged on an inner surface of the support and electrically connected to the light-emitting elements. The electrical connector is fixed to the support and electrically connected to the electrical conductive circuit. The transparent body is over-molded outside the electrical conductive circuit and the electrical connector. The lamp cover is over-molded outside the electrical connector and the transparent body.

In comparison with prior art, the present invention has advantageous features as follows. The transparent body and the lamp cover are over-molded by an injection-forming process, so that the electrostatic discharge (ESD) generated by the repeated touch of fingers of operators in assembly can be reduced. In this way, the yield and stability of the product can be increased. Further, the labor and time for assembly can be reduced greatly because the production procedure is simplified. Further, the transparent body is formed with light-guiding posts for controlling the light emitted by the light-emitting elements in a certain range of angles accurately.

### BRIEF DESCRIPTION OF THE DRAWINGS

FIG. 1 is an exploded view showing the metallic support and the electrical conductive circuit of the present invention;
FIG. 2 is an exploded view showing the metallic support, the electrical conductive circuit and the electrical connector of the present invention;
FIG. 3 is an assembled view showing the covering structure and the light-emitting elements of the present invention;
FIG. 4 is a cross-sectional view of FIG. 3;
FIG. 5 is an assembled cross-sectional view showing the construction of the present invention after the transparent body is over-molded;
FIG. 6 is an assembled cross-sectional view showing the construction of the present invention after the lamp cover is over-molded;
FIG. 7 is an exploded view showing the illuminating device of the present invention and a docking connector;
FIG. 8 is an assembled view showing the illuminating device of the present invention and a docking connector; and
FIG. 9 is an assembled cross-sectional view showing another embodiment of the present invention.

### DETAILED DESCRIPTION OF THE INVENTION

The characteristics and technical contents of the present invention will be explained with reference to the accompanying drawings. However, the drawings are illustrative only but not used to limit the present invention.

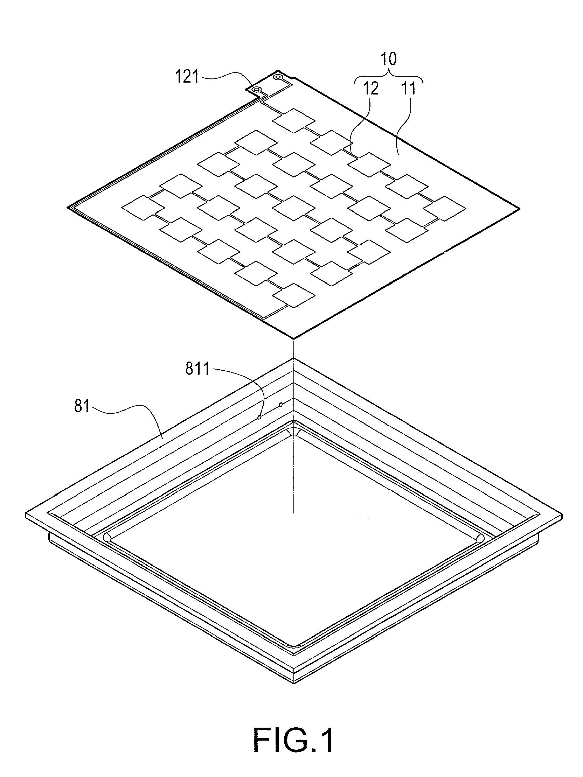

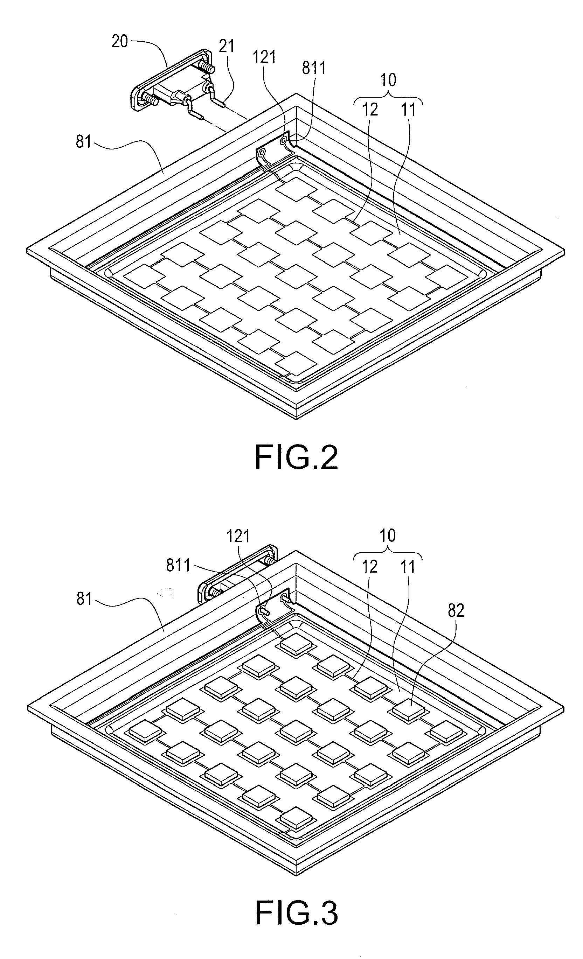

Please refer to FIGS. 1 to 4. The present invention provides an electrical conductive covering structure of an illuminating device. The illuminating device 8 includes a metallic support 81 and a plurality of light-emitting elements 82. In the present embodiment, the metallic support 81 is formed as a box having an open end. The light-emitting elements 82 may be bare dies of LED or LEDs packaged with lenses. The electrical conductive covering structure includes an electrical conductive circuit 10, an electrical connector 20, a transparent body 30 and a lamp cover 40.

The electrical conductive circuit 10 is constituted of an insulating layer 11 and a copper-clad circuit layer 12. The insulating layer 11 is adhered to an inside surface of the metallic support 81. The light-emitting elements 82 are fixed on the insulating layer 11 with their terminals (not shown) being electrically connected to the copper-clad circuit layer 12. Further, a side plate of the metallic support 81 is provided with a pair of through-holes 811. The copper-clad circuit layer 12 of the electrical conductive circuit 20 is formed with a pair of contacts 121 corresponding to the through-holes 11 respectively.

In the present embodiment, the electrical connector 20 is a socket having a pair of electrical conductive rods 21. The pair of electrical conductive rods 21 is inserted into the through-holes 811 of the metallic support 81 respectively to be electrically connected with the contacts 121 of the electrical conductive circuit 20.

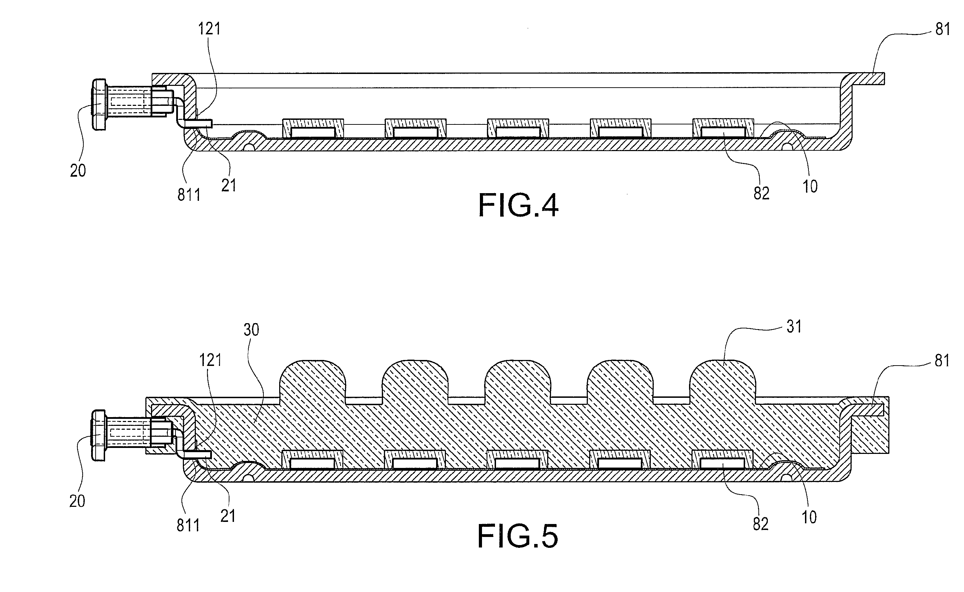

Please refer to FIG 5. The semi-product shown in FIG. 4 is disposed in a pre-formed mold (not shown). Epoxy, polycarbonate (PC) and other suitable materials are heated and melted, and then the molten material is injected into the mold. The molten material flows over the electrical conductive circuit 10, the light-emitting elements 82 and cover the metallic support 81 and the electrical connector 20 partially. After solidification, a transparent body 30 is formed and taken away from the mold. A light-guiding post 31 is formed at a position corresponding to each of the light-emitting elements 82.

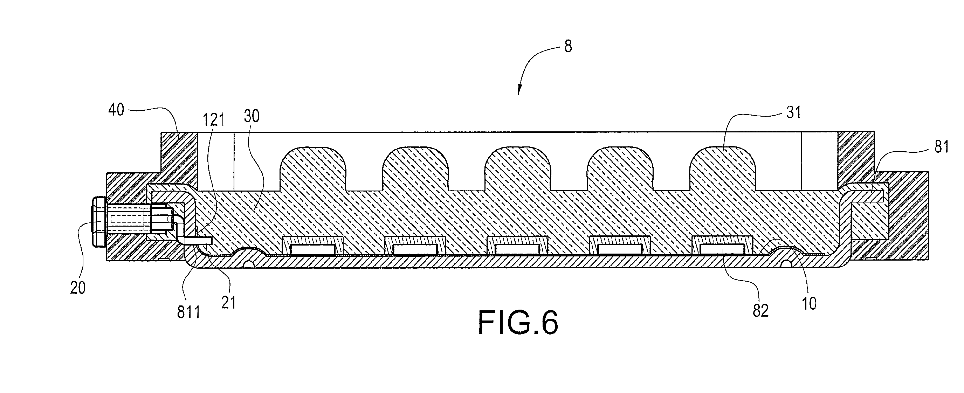

Please refer to FIG 6. The semi-product shown in FIG. 5 is then disposed in a pre-formed mold (not shown). After engineering plastics or other suitable materials are heated and melted, the molten material is injected into the mold and then over-molded outside the transparent body 30, the metallic support 81, and the electrical connector 20. After solidification, a lamp cover 40 is formed, and the lamp cover 40 is taken away from the mold.

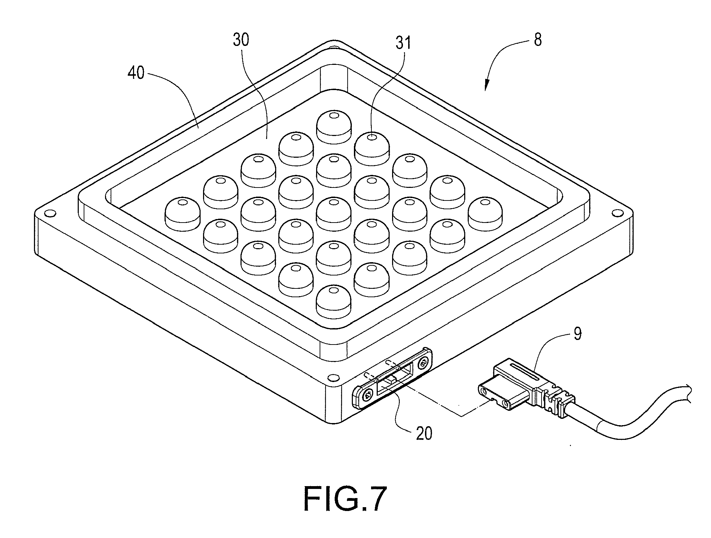

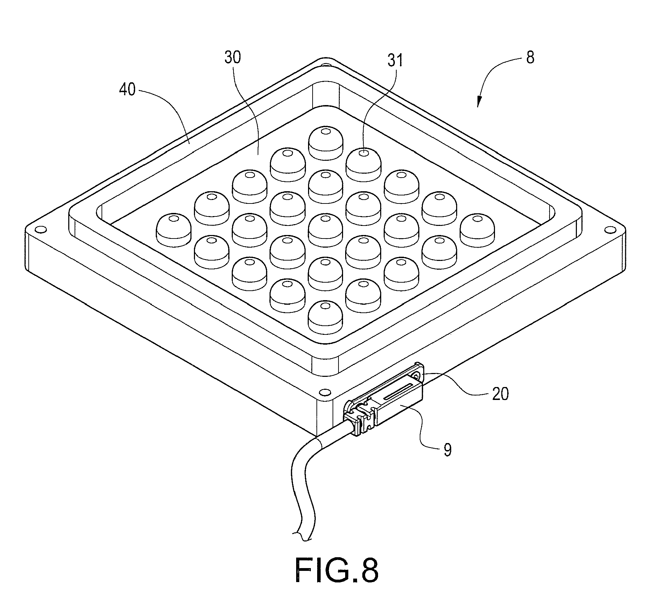

Please refer to FIGS. 7 and 8. A docking connector 9 can be inserted into or removed from the electrical connector 20 partially covered by the lamp cover 40. Thus, the illuminating device 8 can be used more easily and conveniently.

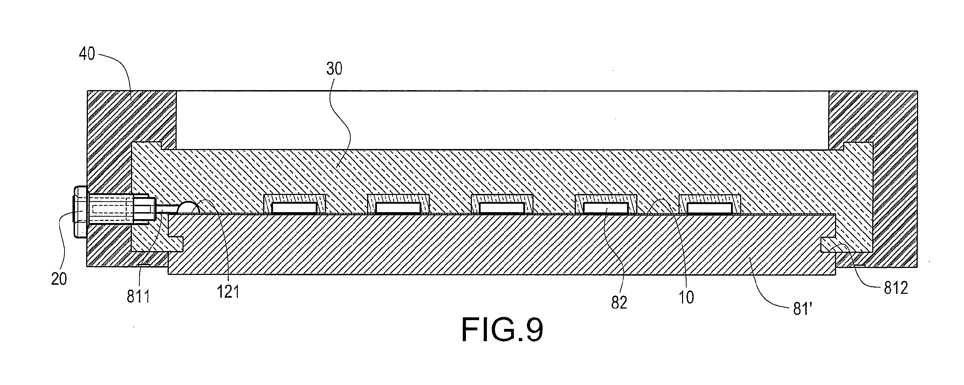

Please refer to FIG. 9. In addition to the metallic support 81 of the previous embodiment, a thickened metallic support 81' shown in the present embodiment can be used. The side surface of the metallic support 81' is provided with an annular groove 812. When the transparent body 30 is over-molded outside the electrical conductive circuit 10 and the electrical connector 20, the transparent body 30 can be inserted into the groove 812 and fixed thereto. In this way, the transparent body 30 and the metallic support 81' can be combined with each other more tightly. Further, the upper surface of the transparent body 30 is a flat surface. The lamp cover 40 is over-molded on the transparent body 30, the electrical connector 20 and a portion of metallic support 81'. With this arrangement, the present embodiment can achieve the same effect as the previous embodiment.

According to the above, the electrical conductive covering structure of an illuminating device according to the present invention really demonstrates industrial applicability, novelty and inventive steps. Further, the structure of the present invention has not been seen in product of the same kind or let in public use. Thus, the present invention conforms to the requirements for an invention patent.

## Claims

1. An electrical conductive covering structure of an illuminating device, the illuminating device (8) comprising a support (81) and a plurality of light-emitting elements (82), the electrical conductive covering structure including:
an electrical conductive circuit (10) arranged on an inner surface of the support (81) and electrically connected with the light-emitting elements (82);
an electrical connector (20) fixed to the support (81) and electrically connected with the electrical conductive circuit (10);
a transparent body (30) over-molded outside the electrical conductive circuit (10) and the electrical connector (20); and
a lamp cover (40) over-molded outside the electrical connector (20) and the transparent body (30).

2. The electrical conductive covering structure of an illuminating device according to claim 1, wherein the electrical conductive circuit (10) comprises an insulating layer (11) adhered to the support (81) and a copper-clad circuit layer (12) arranged above the insulating layer (11).

3. The electrical conductive covering structure of an illuminating device according to claim 2, wherein the electrical connector (20) has a pair of electrical conductive rods (21), the support (81) is provided with a pair of through-holes (811), and the pair of electrical conductive rods (21) is inserted into the through-holes (811).

4. The electrical conductive covering structure of an illuminating device according to claim 3, wherein the copper-clad circuit layer (12) is formed with a pair of contacts (121), and the pair of contacts (121) is arranged to correspond to the through-holes (811) for allowing the electrical conductive rods (21) to be electrically connected therewith.

5. The electrical conductive covering structure of an illuminating device according to claim 2, wherein the electrical connector (20) has a pair of electrical conductive rods (21), the copper-clad circuit layer (12) is formed with a pair of contacts (121), and the pair of contacts (121) is electrically connected with the pair of electrical conductive rods (21).

6. The electrical conductive covering structure of an illuminating device according to claim 1, wherein the transparent body (30) is over-molded outside the electrical conductive circuit (10) and the electrical connector (20) by an injection-forming process.

7. The electrical conductive covering structure of an illuminating device according to claim 1, wherein the lamp cover (40) is over-molded outside the electrical connector (20) and the transparent body (30) by an injection-forming process.

8. The electrical conductive covering structure of an illuminating device according to claim 1, wherein the transparent body (30) is made of epoxy or polycarbonate.

9. The electrical conductive covering structure of an illuminating device according to claim 1, wherein the transparent body (30) is formed with a light-guiding post (31) at a position corresponding to that of the light-emitting element (82).

10. The electrical conductive covering structure of an illuminating device according to claim 1, wherein the support (81') is provided with a groove (812), the transparent body (30) is inserted into the groove (812) and fixed thereto.
